# EUROPEAN PATENT APPLICATION

(11) **EP 4 489 074 A1**
(43) Date of publication of application: **08.01.2025**
(21) Application number: 23193869.7
(22) Date of filing: 29.08.2023
(51) Int. Cl.: H01L 27/12, H01L 29/786

(54) **ARRAY SUBSTRATE AND DISPLAY PANEL**

(30) Priority: 07.07.2023 CN 202310828547
(71) Applicant: Shenzhen China Star Optoelectronics Semiconductor Display Technology Co., Ltd., Shenzhen, Guangdong 518132 (CN)
(72) Inventor: LUO, Chuanbao, Shenzhen, Guangdong (CN)
(74) Representative: Herrero & Asociados, S.L.

(57) **Abstract**

An array substrate (10) includes a substrate (101) and a first transistor (T1) disposed thereon. The first transistor (T1) includes a first active layer (103), a first channel portion (1031), a first doped portion (1032), a second doped portion (1033), a first gate (105), a source (1081) and a drain (1082). The first doped portion (1032) and the second doped portion (1033) are connected to opposite ends of the first channel portion (1031), respectively. The first doped portion (1032) includes a first doped sub-portion (10321) and a second doped sub-portion (10322) connected between the first channel portion (1031) and the first doped sub-portion (10321). A doping concentration of ions in the second doped sub-portion (10322) is less than that in the first doped sub-portion (10321), and a doping concentration of ions in the first doped sub-portion (10321) is the same as that in the second doped portion (1033).

## Description

### TECHNICAL FIELD

The present disclosure relates to the field of display, and in particular, to an array substrate and a display panel.

### BACKGROUND OF INVENTION

Currently, it is a research hotspot in the technical field of display to develop transistors with high mobility so as to improve the performance of a display panel. However, transistors with high mobility suffer from poor stability in operation.

Therefore, how to improve the poor stability of transistors with high mobility is a technical problem to be solved.

### SUMMARY OF INVENTION

An object of the present disclosure is to provide an array substrate and a display panel to improve poor stability of transistors.

According to a first aspect, the present disclosure provides an array substrate including:
a substrate; and
a first transistor disposed on the substrate; wherein the first transistor includes:
a first active layer disposed on the substrate, and the first active layer includes a first channel portion, a first doped portion, and a second doped portion; the first doped portion and the second doped portion are connected to opposite ends of the first channel portion, respectively; the first doped portion includes a first doped sub-portion and a second doped sub-portion, and the second doped sub-portion is connected between the first channel portion and the first doped sub-portion; a doping concentration of ions in the second doped sub-portion is less than a doping concentration of ions in the first doped sub-portion, and the doping concentration of ions in the first doped sub-portion is the same as a doping concentration of ions in the second doped portion;
a first gate disposed on one side of the first active layer, and the first gate overlaps with the first channel portion; and
a source and a drain, the source is connected to the second doped portion and the drain connected to the first doped sub-portion of the first doped portion.

In a second aspect, the present disclosure provides a display panel including the above array substrate.

Advantageously, since the doping concentration of ions in the second doped sub-portion is less than the doping concentration of ions in the first doped sub-portion, and the doping concentration of ions in the first doped sub-portion is the same as a doping concentration of ions in the second doped portion, the resistance of the second doped sub-portion is greater than that of the first doped sub-portion, thereby reducing the voltage drop of the first doped portion connected to the drain, and improving the problem of poor stability of the first transistor due to self-heating.

### BRIEF DESCRIPTION OF THE DRAWINGS

FIGs. 1A to 1H are schematic structural diagrams of a process for manufacturing an array substrate according to some embodiments of the present disclosure.
FIG. 2 is a schematic structural diagram of an array substrate according to some embodiments of the present disclosure.
FIG. 3 is a schematic structural diagram of an array substrate according to other embodiments of the present disclosure.
FIG. 4 is a schematic cross-sectional view of a display panel according to some embodiments of the present disclosure.
FIG. 5 is a schematic cross-sectional view of a display panel according to other embodiments of the present disclosure.

### Description of reference signs:

30, display panel; 10, array substrate; 201, light-emitting device layer; 2011, light-emitting device; 202, opposing substrate; 203, liquid crystal layer;
101, substrate; 102, buffer layer;
103a, first semiconductor layer; 103, first active layer; 1031, first channel portion; 1032a, first initial doped portion; 1032a1, first region; 1032a2, second region; 1032, first doped portion; 10321, first doped sub-portion; 10322, second doped sub-portion; 1033a, second initial doped portion; 1033, second doped portion;
1041, fourth insulating layer; 1042, first insulating layer; 1043, second insulating layer; 1044, third insulating layer;
105, first gate;
106a, second semiconductor layer; 106, second active layer; 1061, second channel portion; 1062, third doped portion; 1063, fourth doped portion;
107, second gate;
10a, first via; 10d, second via; 10b, third via; 10e, fourth via; 10c, fifth via; 10f, sixth via;
1081, source; 1082, drain;
T1, first transistor; T2, second transistor.

### EMBODIMENTS OF INVENTION

Hereinafter, technical solutions in embodiments of the present disclosure will be clearly and completely described with reference to the accompanying drawings in embodiments of the present disclosure. Apparently, the described embodiments include but are not limited to the embodiments of the present disclosure. Other embodiments that can be obtained by a person with ordinary skill in the art on the basis of the embodiments in the present disclosure without creative labor belong to the protection scope of the present disclosure.

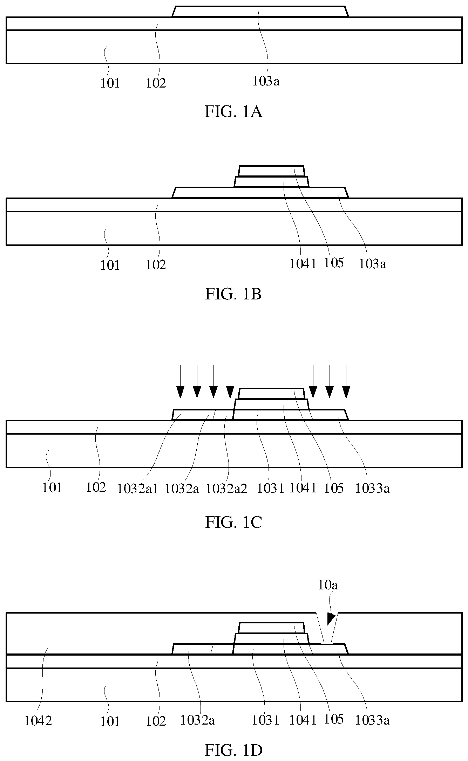

Referring to FIGs. 1A to 1H, which are schematic structural diagrams of a process for manufacturing an array substrate according to some embodiments of the present disclosure. The process for manufacturing an array substrate according to some embodiments of the present disclosure is described in detail with reference to FIGs. 1A to 1H.

Referring to FIG. 1A, firstly, forming a first semiconductor layer 103a on the substrate 101.

In some embodiments, as shown in FIG. 1A, before the step of forming a first semiconductor layer 103a on the substrate 101, the process for manufacturing the array substrate further includes forming a buffer layer 102 on the substrate 101.

Illustratively, the substrate 101 includes a glass substrate, but is not limited thereto. The substrate 101 may also be a flexible substrate including a polymer layer.

Illustratively, the buffer layer 102 includes, but is not limited to, a silicon oxide layer, a silicon nitride layer, a silicon oxynitride layer, or a stacked layer of a silicon nitride layer and a silicon oxide layer.

In some embodiments, the step of forming a first semiconductor layer 103a on the substrate 101 includes forming a first semiconductor layer 103a on a surface of the buffer layer 102 away from the substrate 101.

In some embodiments, the first semiconductor layer 103a is a single semiconductor layer. Materials of the first semiconductor layer 103a include amorphous silicon, polysilicon, or metal oxides.

Polysilicon can be obtained by subjecting amorphous silicon to laser annealing crystallization or other crystallization methods. The metal oxide includes at least one of indium element, zinc element, tungsten element, tin element, gallium element, and aluminum element. Illustratively, the material of the metal oxide includes, but is not limited to a metal oxide with low leakage current, such as indium gallium zinc oxide (IGZO), indium gallium tin oxide (IGTO), indium gallium oxide (IGO), indium zinc oxide (IZO), aluminum indium zinc oxide (AIZO), aluminum tin zinc oxide (ATZO), or the like.

Next, referring to FIG. 1B, forming a first gate 105 overlapping with the first semiconductor layer 103a on one side of the first semiconductor layer 103a away from the substrate 101.

In some embodiments, as shown in FIG. 1B, before the step of forming a first gate 105 overlapping with the first semiconductor layer 103a on the side of the first semiconductor layer 103a away from the substrate 101, the process for manufacturing the array substrate further includes forming a fourth insulating layer 1041 on the first semiconductor layer 103a. The fourth insulating layer 1041 overlaps with part of the first semiconductor layer 103a.

The fourth insulating layer 1041 is a first gate insulating layer. In some embodiments, the material of the fourth insulating layer 1041 includes, but is not limited to, at least one of silicon oxide, aluminum oxide, and silicon nitride. Illustratively, the fourth insulating layer 1041 includes a silicon oxide layer, or a stacked layer of an aluminum oxide layer, a silicon nitride layer and a silicon oxide layer, or a stacked of a silicon oxide layer, a silicon nitride layer and a silicon oxide layer.

In some embodiments, the step of forming a first gate 105 overlapping the first semiconductor layer 103a on one side of the first semiconductor layer 103a away from the substrate 101 includes forming a first gate 105 on one side of the fourth insulating layer 1041 away from the substrate 101.

In some embodiments, the material of the first gate 105 includes, but is not limited to, at least one of molybdenum, aluminum, copper, titanium, indium zinc oxide, and indium tin oxide. Illustratively, the first gate 105 includes a molybdenum layer (Mo), or a stacked layer of a molybdenum layer and an aluminum layer (Mo/Al), or a stacked layer of a molybdenum layer and a copper layer (Mo/Cu), or a stacked layer of a molybdenum-titanium alloy layer and a copper layer (MoTi/Cu), or a stacked layer of a molybdenum-titanium alloy layer, a copper layer, and a molybdenum-titanium alloy layer that are sequentially stacked (MoTi/Cu/MoTi), or a stacked layer of a titanium layer, an aluminum layer, and a titanium layer that are sequentially stacked (Ti/Al/Ti), or a stacked of a titanium layer, a copper layer, and a titanium layer that are sequentially stacked (Ti/Cu/Ti), or a stacked of a molybdenum layer, a copper layer, and an indium zinc oxide layer that are sequentially stacked (Mo/Cu/IZO), or a stacked layer of a zinc oxide layer, a copper layer, and a zinc oxide layer that are sequentially stacked (IZO/Cu/IZO).

Next, referring to FIG. 1C, doping the first semiconductor layer 103a for the first time by using the first gate 105 as a mask, so that the first semiconductor layer 103a subjected to the first doping process is formed with a first initial doped portion 1032a, a second initial doped portion 1033a and a first channel portion 1031. The first initial doped portion 1032a and the second initial doped portion 1033a are connected to opposite ends of the first channel portion 1031, respectively.

In some embodiments of the present disclosure, after the first semiconductor layer 103a is doped for the first time by using the first gate 105 as a mask, the doped portions of the first semiconductor layer 103a form the first initial doped portion 1032a and the second initial doped portion 1033a, respectively, and the undoped portion of the first semiconductor layer 103a forms the first channel portion 1031. A doping concentration of ions in the first initial doped portion 1032a is the same as that in the second initial doped portion 1033a. Both the first initial doped portion 1032a and the second initial doped portion 1033a have conductivity. An orthographic projection of the first channel portion 1031 on the substrate 101 completely overlaps with an orthographic projection of the first gate 105 on the substrate 101. In other words, the orthographic projection of the first channel portion 1031 on the substrate 101 is basically the same as the the orthographic projection of the first gate 105 on the substrate 101.

In some embodiments, the length of the first initial doped portion 1032a is greater than the length of the second initial doped portion 1033a, and the length of the first initial doped portion 1032a is long enough to facilitate subsequent differential design of the resistances in different regions of the first initial doped portion 1032a. Meanwhile, in the direction perpendicular to the thickness of the substrate 101, that is, in the horizontal direction, a distance between an edge of the first gate 105 close to the first initial doped portion 1032a and an edge of the first initial doped portion 1032a away from the first channel portion 1031 is greater than a distance between an edge of the first gate 105 close to the second initial doped portion 1033a and an edge of the second initial doped portion 1033a away from the first channel portion 1031.

In other embodiments, the length of the first initial doped portion 1032a may also be less than or equal to the length of the second initial doped portion 1033a.

In some embodiments of the present disclosure, the first initial doped portion 1032a has a first region 1032a1 and a second region 1032a2. The second region 1032a2 is located between the first region 1032a1 and the first channel portion 1031. For part of the first initial doped portion 1032a located in the first region 1032a1, it is necessary to further perform process of doping ions. For part of the first initial doped portion 1032a located in the second region 1032a2, no further process of doping ions is required.

In some embodiments, the first doping is N-type heavy doping or P-type heavy doping. N-type heavily doped ions include, but are not limited to, phosphorus ions. P-type heavily doped ions include, but are not limited to, boron ions.

In some embodiments, the doping concentration of the first doping ranges from 1×10¹⁴/cm² to 9×10¹⁴/cm². Illustratively, the doping concentration of the first doping is 4×10¹⁴/cm².

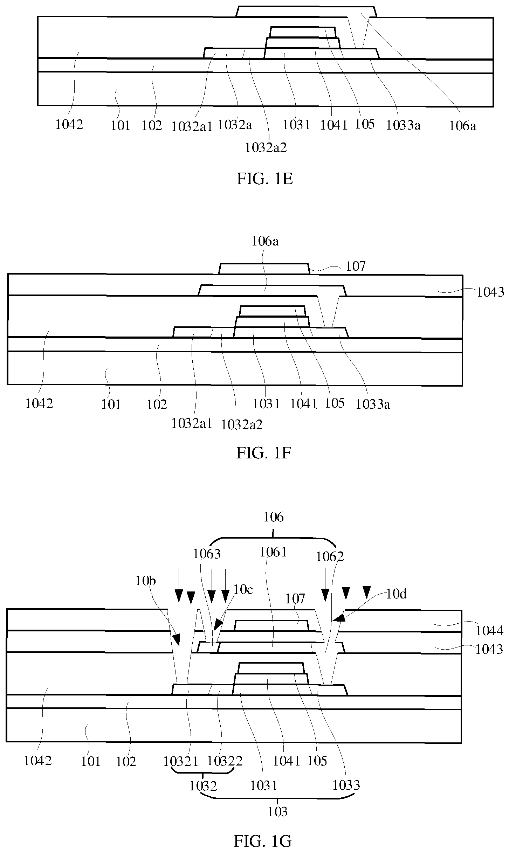

Next, referring to FIG. 1E, forming a second semiconductor layer 106a on one side of the first gate 105 away from the substrate 101. The second semiconductor layer 106a overlaps with the first channel portion 1031, the second region 1032a2, part of the first region 1032a1 and the second initial doped portion 1033a.

In some embodiments, as shown in FIG. 1D, before the step of forming a second semiconductor layer 106a on one side of the first gate 105 away from the substrate 101, the process for manufacturing the array substrate further includes forming a first insulating layer 1042 covering the first gate 105, the first initial doped portion 1032a, the second initial doped portion 1033a and the buffer layer 102, and forming a first via 10a overlapping with the second initial doped portion 1033a in the first insulating layer 1042.

In some embodiments, the material of the first insulating layer 1042 includes, but is not limited to, at least one of silicon oxide, silicon oxynitride, aluminum oxide, and silicon nitride. Illustratively, the first insulating layer 1042 includes any one of a silicon oxide layer, a silicon nitride layer, a silicon oxynitride layer, and or a stacked layer of a silicon nitride layer and a silicon oxide layer.

In some embodiments, referring to FIG. 1E, the step of forming the second semiconductor layer 106a on the side of the first gate 105 away from the substrate 101 includes forming the second semiconductor layer 106a on the surface of the first insulating layer 1042 away from the substrate 101 and in the first via 10a.

Illustratively, the second semiconductor layer 106a is a single semiconductor layer. The material of the second semiconductor layer 106a includes, but is not limited to, amorphous silicon, polysilicon, or metal oxides. The selection of the polysilicon and the metal oxides is as described above, and details are not described herein.

In some embodiments, the material of the second semiconductor layer 106a is the same as, but not limited to, the material of the first semiconductor layer 103a. Illustratively, both the second semiconductor layer 106a and the first semiconductor layer 103a are metal oxide semiconductor layers.

In other embodiments, the material of the second semiconductor layer 106a may be different from the material of the first semiconductor layer 103a. Illustratively, the first semiconductor layer 103a is a metal oxide semiconductor layer, and the second semiconductor layer 106a is a polysilicon semiconductor layer.

Next, referring to FIGs. 1F and 1G, forming a second gate 107 on one side of the second semiconductor layer 106a away from the substrate 101; and doping the second semiconductor layer 106a, part of the first initial doped portion 1032a located in the first region 1032a1 and the second initial doped portion 1033a for a second time by using the second gate 107 as a mask, so that the doped second semiconductor layer 106a is formed with a second active layer 106, and part of the first initial doped portion 1032a located in the first region 1032a1 and the second initial doped portion 1033a form the first doped sub-portion 10321 and the second doped portion 1033, respectively.

In some embodiments of the present disclosure, before the step of forming the second gate 107 on the side of the second semiconductor layer 106a away from the substrate 101, the process for manufacturing the array substrate further includes a step of forming a second insulating layer 1043 covering the second semiconductor layer 106a and the first insulating layer 1042.

The second insulating layer 1043 is a second gate insulating layer. In some embodiments, the material of the second insulating layer 1043 includes, but is not limited to, at least one of silicon oxide, aluminum oxide, and silicon nitride. Illustratively, the second insulating layer 1043 includes a silicon oxide layer, or a stacked layer of an aluminum oxide layer, a silicon nitride layer and a silicon oxide layer, or a stacked layer of a silicon oxide layer, a silicon nitride layer and a silicon oxide layer.

In some embodiments of the present disclosure, after the second semiconductor layer 106a, part of the first initial doped portion 1032a located in the first region 1032a1 and the second initial doped portion 1033a are doped for the second time by using the second gate 107 as a mask, the doped portions in the second semiconductor layer 106a form a third doped portion 1062 and a fourth doped portion 1063, respectively; and the undoped portion in the second semiconductor layer 106a forms a second channel portion 1061. The third doped portion 1062, and the fourth doped portion 1063 are connected to opposite sides of the second channel portion 1061, respectively. The second channel portion 1061, the third doped portion 1062, and the fourth doped portion 1063 constitute the second active layer 106.

Furthermore, part of the first initial doped portion 1032a located in the first region 1032a1 that is subjected to the second doping forms the first doped sub-portion 10321. The second initial doped portion 1033a that is subjected to the second doping forms the second doped portion 1033. While part of the first initial doped portion 1032a located in the second region 1032a2 that is not subjected to the second doping forms the second doped sub-portion 10322. The first doped sub-portion 10321 and the second doped sub-portion 10322 constitute the first doped portion 1032. The first doped portion 1032, the second doped portion 1033 and the first channel portion 1031 constitute the first active layer 103.

In some embodiments of the present disclosure, an orthographic projection of the second channel portion 1061 on the substrate 101 completely overlaps with an orthographic projection of the second gate 107 on the substrate 101. In other words, the orthographic projection of the second channel portion 1061 on the substrate 101 is basically the same as the orthographic projection of the second gate 107 on the substrate 101.

In some embodiments of the present disclosure, the second channel portion 1061 overlaps with the first channel portion 1031 and the second doped sub-portion 10322; and the third doped portion 1062 overlaps with the second doped portion 1033; so that the second channel portion 1061 overlaps with the first channel portion 1031, and the length of the second channel portion 1061 is greater than that of the first channel portion 1031, thereby facilitating the formation of the second active layer 106 and the first active layer 103 simultaneously by using a self-alignment process in combination with a process of doping ions by using the second gate 107 as a mask, thus further reducing the number of masks required for manufacturing the array substrate.

In some embodiments of the present disclosure, since the third doped portion 1062 and the fourth doped portion 1063 are formed by the same primary doping process with the second gate 107 as a mask, the doping concentration of ions in the third doped portion 1062 is the same as that in the fourth doped portion 1063, and the third doped portion 1062 and the fourth doped portion 1063 have conductivity due to the ions doped therein. Moreover, the third doped portion 1062 is contacted and connected with the second doped portion 1033 through the first via 10a, so that wirings connecting the third doped portion 1062 and the second doped portion 1033 are reduced, and the number of masks required for manufacturing the wirings is further reduced.

In some embodiments of the present disclosure, since both the first doped sub-portion 10321 and the second doped portion 1033 are formed through the first doping and the second doping, while the second doped sub-portion 10322 is formed through only the first doping, the doping concentration of ions in the first doped sub-portion 10321 is the same as that in the second doped portion 1033, and the doping concentration of ions in the second doped sub-portion 10322 is lower than that in the first doped sub-portion 10321. As a result, the resistance of the second doped sub-portion 10322 is greater than that of the first doped sub-portion 10321, which reduces the voltage drop of the first doped portion 1032 that needs to be connected to the drain.

In some embodiments of the present disclosure, a ratio of the doping concentration of ions in the second doped sub-portion 10322 to the doping concentration of ions in the first doped sub-portion 10321 is greater than or equal to 0.02 and less than or equal to 0.1, which can increase the resistance of the second doped sub-portion 10322 while reduce the resistance of the first doped sub-portion 10321, thus reducing the connection impedance between the first doped sub-portion 10321 and the drain while reducing the voltage drop of the first doped sub-portion 1032 that needs to be connected to the drain.

In some embodiments, both the first doping and the second doping are N-type heavy doping, or both the first doping and the second doping are P-type heavy doping.

In some embodiments, the dopant ions used in first doping are the same as those in the second doping, but is not limited thereto, for example, the dopant ions used in first doping may also be different from those in the second doping.

Illustratively, the second doping is N-type heavy doping or P-type heavy doping. N-type heavily doped ions include, but are not limited to, phosphorus ions. P-type heavily doped ions include, but are not limited to, boron ions. The doping concentration in the second doping ranges from 1×10¹⁴/cm² to 9×10¹⁴/cm².

In some embodiments, the thickness of the second active layer 106 is less than that of the first active layer 103, which is beneficial for the first active layer 103 to form a crystalline phase more easily during thermal annealing.

In some embodiments, after the step of forming the first active layer 103 and the second active layer 106, the process for manufacturing the array substrate further includes subjecting the first active layer 103 to an annealing process to form a crystalline phase, and allowing the second active layer 106 to include an amorphous phase, so as to improve the performance stability of the first active layer 103 and maintain the semiconductor characteristics of the second active layer 106.

In some embodiments, after the step of doping the second semiconductor layer 106a, part of the first initial doped portion 1032a located in the first region 1032a1 and the second initial doped portion 1033a for the second time, the process for manufacturing the array substrate further includes a step of forming a third insulating layer 1044 covering the second gate 107 and the second insulating layer 1043.

In some embodiments, referring to FIG. 1G, after the step of forming the third insulating layer 1044 covering the second gate 107 and the second insulating layer 1043, a third via 10b, a fifth via 10c, and a second via 10d are formed. The third via 10b overlaps with the first doped sub-portion 10321, and penetrates through the third insulating layer 1044, the second insulating layer 1043, and the first insulating layer 1042. The fifth via 10c overlaps with the fourth doped portion 1063, and penetrates through the third insulating layer 1044 and the second insulating layer 1043. The second via 10d overlaps with the third doped portion 1062, and penetrates through the third insulating layer 1044 and the second insulating layer 1043.

In some embodiments, the third via 10b, the fifth via 10c, and the second via 10d are formed by using a process combing mask with etching, so as to reduce the number of masks required for manufacturing the array substrate.

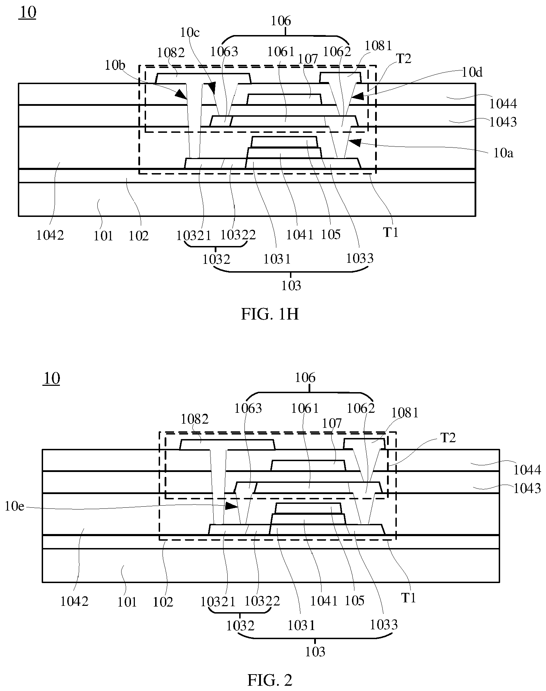

In some embodiments, referring to FIG. 1H, forming a source 1081 and a drain 1082. The drain 1082 is formed in the third via 10b, in the fifth via 10c, and on a surface of the third insulating layer 1044 away from the substrate 101. The source 1081 is formed in the second via 10d, and on a surface of the third insulating layer 1044 away from the substrate 101. In this way, the drain 1082 is connected to the fourth doped portion 1063 and the first doped sub-portion 10321, and the source 1081 is connected to the third doped portion 1062 and the second doped portion 1033.

In some embodiments, the materials of source 1081 and drain 1082 include but are not limited to, at least one of molybdenum, aluminum, copper, titanium, indium zinc oxide, and indium tin oxide. Illustratively, the source 1081 and the drain 1082 include a molybdenum layer (Mo), or a stacked layer of a molybdenum layer and an aluminum layer (Mo/Al), or a stacked layer of a molybdenum layer and a copper layer (Mo/Cu), or a stacked layer of a molybdenum-titanium alloy layer and a copper layer (MoTi/Cu), or a stacked layer of a molybdenum-titanium alloy layer, a copper layer, and a molybdenum-titanium alloy layer that are sequentially stacked (MoTi/Cu/MoTi), or a stacked layer of a titanium layer, an aluminum layer, and a titanium layer that are sequentially stacked (Ti/Al/Ti), or a stacked of a titanium layer, a copper layer, and a titanium layer that are sequentially stacked (Ti/Cu/Ti), or a stacked of a molybdenum layer, a copper layer, and an indium zinc oxide layer that are sequentially stacked (Mo/Cu/IZO), or a stacked layer of a zinc oxide layer, a copper layer, and a zinc oxide layer that are sequentially stacked (IZO/Cu/IZO).

In some embodiments of the present disclosure, transistors are formed by the above method. The transistors include a first transistor T1 and a second transistor T2 disposed in parallel, so as to increase the mobility of the transistors. The first transistor T1 is a narrow channel transistor, which further increases the mobility of the transistor. The first transistor T1 includes a source 1081, a drain 1082, a first active layer 103, and a first gate 105. The second transistor T2 includes a second active layer 106, a second gate 107, a source 1081, and a drain 1082. The first transistor T1 and the second transistor T2 are connected through the third doped portion 1062, and the first transistor T1 and the second transistor T2 share the source 1081 and the drain 1082, thereby saving the number of masks required for manufacturing the array substrate. Furthermore, the film layers of the first transistor T1 and the second transistor T2 are stacked, so that high mobility of the transistor is realized on the premise of reducing the horizontal space occupied by the transistors, the self-heating problem of the transistors is also improved, thus improving the performance stability of the transistors.

Referring to FIG. 1H, which is a s schematic structural view of a display panel according to some embodiments of the present disclosure. The array substrate 10 includes a substrate 101, a first transistor T1, and a second transistor T2. Both the first transistor T1 and the second transistor T2 are disposed on the substrate 101.

In some embodiments, the array substrate 10 further includes a buffer layer 102 disposed between the first transistor T1 and the substrate 101.

The first transistor T1 includes a first active layer 103, a first gate 105, a source 1081, and a drain 1082. The first active layer 103 is disposed on the substrate 101. The first gate 105 is disposed on one side of the first active layer 103.

Specifically, the first gate 105 is disposed on one side of the first active layer 103 away from the substrate 101, that is, the first thin film transistor T1 is a top-gate thin film transistor, so that the first gate 105 can be used as a mask to form the first active layer 103 by doping with ions, thereby reducing the number of masks required for manufacturing the array substrate 10.

In other embodiments, the first gate 105 may also be disposed between the first active layer 103 and the substrate 101. In other words, the first transistor T1 may also be a bottom-gate thin film transistor.

In some embodiments, the first active layer 103 includes a crystalline phase to improve the performance stability of the first transistor T1.

In some embodiments, the first active layer 103 includes a first channel portion 1031, a first doped portion 1032, and a second doped portion 1033, The first doped portion 1032 and the second doped portion 1033 are connected to opposite ends of the first channel portion 1031, respectively. The first gate 105 overlaps with the first channel portion 1031. The first doped portion 1032 includes a first doped sub-portion 10321 and a second doped sub-portion 10322, and the second doped sub-portion 10322 is connected between the first channel portion 1031 and the first doped sub-portion 10321. The doping concentration of ions in the second doped sub-portion 10322 is less than that in the first doped sub-portion 10321. The doping concentration of ions in the first doped sub-portion 10321 is the same as that in the second doped portion 1033. The source 1081 is connected to the second doped portion 1033, and the drain 1082 is connected to the first doped sub-portion 10321 of the first doped portion 1032. Due to this design, the resistance of the second doped sub-portion 10322 is greater than that of the first doped sub-portion 10321, which reduces the voltage drop of the first doped portion 1032 connected to the drain 1082, thereby improving the problem of poor stability caused by heat generation in the first transistor caused by hot carriers, and reducing the connection impedance between the drain 1082 and the first doped sub-portion 10321.

In some embodiments, along the direction in which the first active layer 103 extends from the first doped portion 1032 to the second doped portion 1033, the length of the first doped portion 1032 is greater than that of the second doped portion 1033, so as to realize differential design of the resistances in different regions of the first doped portion 1032 by adopting a process of doping ions. But it is not limited thereto. The length of the first doped portion 1032 may also be less than or equal to that of the second doped portion 1033.

In some embodiments, along the direction in which the first active layer 103 extends from the first doped portion 1032 to the second doped portion 1033, the length of the first doped portion 1032 is greater than that of the second doped portion 1033, which can reduce the voltage drop of the first doped portion 1032, so as to improve the problem of poor stability of the first transistor due to self-heating. Further, the overall resistance of the first doped portion 1032 is small.

In some embodiments, the array substrate 10 further includes a fourth insulating layer 1041, which is a first gate insulating layer. The fourth insulating layer 1041 is disposed between the first gate 105 and the first active layer 103.

In some embodiments, the array substrate 10 further includes a first insulating layer 1042, which is an interlayer insulating layer. The first insulating layer 1042 covers the first gate 105, the first active layer 103, and the buffer layer 102.

The second transistor T2 includes a second active layer 106 and a second gate 107. At least part of the second active layer 106 is located on one side of the first gate 105 away from the substrate 101. Specifically, part of the second active layer 106 is located on the surface of the first insulating layer 1042 away from the substrate 101.

The second gate 107 is located on one side of the second active layer 106 away from the substrate 101, and overlaps with the second channel portion 1061, so that the second gate 107 can be used as a mask to form the second active layer 106 through a process of doping ions, thereby reducing the number of masks required for manufacturing the array substrate 10.

The second active layer 106 includes a second channel portion 1061, a third doped portion 1062, and a fourth doped portion 1063. The third doped portion 1062 and the fourth doped portion 1063 are connected to opposite ends of the second channel portion 1061, respectively.

The third doped portion 1062 is connected to the second doped portion 1033 through the first via hole 10a penetrating through the first insulating layer 1042, so as to realize connection between the first transistor T1 and the second transistor T2, and reduce additional wirings required for connecting the third doped portion 1062 and the second doped portion 1033, thereby further reducing the number of masks required for manufacturing the array substrate 101.

The second channel portion 1061 overlaps with the first channel portion 1031 and the second doped sub-portion 10322. In other words, the length of the second channel portion 1061 is larger than that of the first channel portion 1031. The third doped portion 1062 overlaps with the second doped portion 1033. The fourth doped portion 1063 overlaps with the first doped sub-portion 10321. Due to this design, it is convenient to use the second gate 107 as a mask to form the second active layer 106 through a process of doping ions, and at the same time to use the second gate 107 as a mask to form the first doped sub-portion 10321 and the second doped portion 1033, thereby further reducing the number of masks required for manufacturing the first active layer 103, and reducing the number of masks required for manufacturing the array substrate 10.

In some embodiments, the second active layer 106 includes an amorphous phase to ensure the switching performance of the second transistor T2.

In some embodiments, the thickness of the second active layer 106 is less than that of the first active layer 103, which facilitates easier formation of the first active layer 103 including the crystalline phase during thermal annealing.

In some embodiments, the array substrate 10 further includes a second insulating layer 1043 and a third insulating layer 1044. The second insulating layer 1043 is disposed between the second active layer 106 and the second gate 107. The third insulating layer 1044 covers the second gate 107 and the second insulating layer 1043.

In some embodiments, the first transistor T1 is disposed in parallel with the second transistor T2, so as to increase the mobility of the transistors composed of the first transistor T1 and the second transistor T2.

The source 1081 and the drain 1082 are located on one side of the second gate 107 away from the substrate 101, and both the source 1081 and the drain 1082 are located on the surface of the third insulating layer 1044 away from the substrate 101.

In some embodiments, the drain 1082 is connected to the fourth doped portion 1063 through the fifth via 10c penetrating through the third insulating layer 1044 and the second insulating layer 1043. Further, the drain 1082 is connected to the first doped sub-portion 10321 of the first doped portion 1032 through the third via 10b penetrating through the third insulating layer 1044, the second insulating layer 1043 and the first insulating layer 1042. As a result, parallel connection between the first transistor T1 and the second transistor T2 can be realized.

In some embodiments, the source 1081 is connected to the third doped portion 1062 through the second via 10d, and the third doped portion 1062 is connected to the second doped portion 1033 through the first via 10a, so that the source 1081 is connected to the second doped portion 1033 through the third doped portion 1062, thereby further reducing the wirings connecting the first transistor T1 and the second transistor T2, reducing the number of masks required for manufacturing the wirings, and reducing the cost of manufacturing the array substrate.

Referring to FIG. 2, which is schematic cross-sectional view of a display panel according to other embodiments of the present disclosure. The array substrate shown in FIG. 2 is substantially similar to the array substrate shown in FIG. 1H, and details are not described. The differences lie in that the third doped portion 1062 is connected to the second doped portion 1033 through the first via 10a, and the fourth doped portion 1063 is connected to the first doped sub-portion 10321 through the fourth via 10e, that is, the first transistor T1 and the second transistor T2 are connected in parallel through the third doped portion 1062 and the fourth doped portion 1063 of the second active layer 106, so as to reduce wirings required fro connecting the first transistor T1 and the second transistor T2 in parallel, thereby further reducing the number of masks required for manufacturing the array substrate. The fourth via 10e penetrates through the first insulating layer 1042.

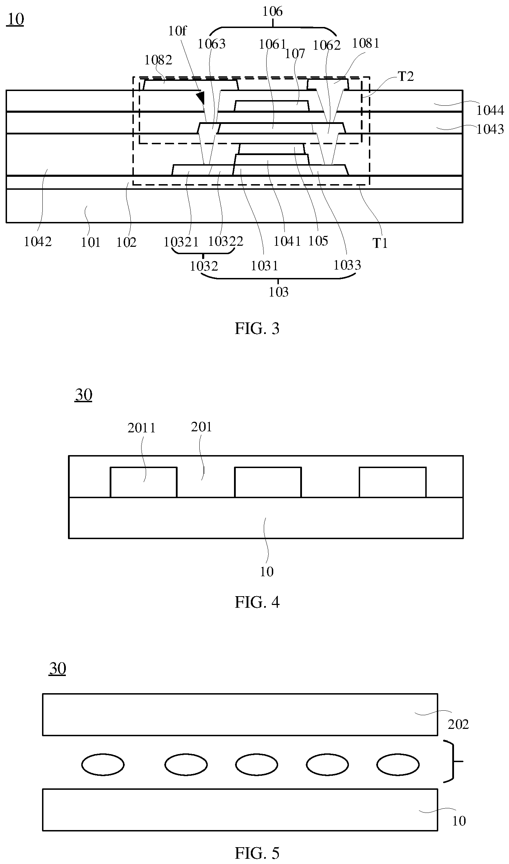

Referring to FIG. 3, which is schematic cross-sectional view of a display panel according to still other embodiments of the present disclosure. The array substrate shown in FIG. 3 is substantially similar to the array substrate shown in FIG. 1H, and details are not described. The differences lie in that the drain 1082 is connected to the fourth doped portion 1063 through the sixth via 10f, and the fourth doped portion 1063 is connected to the first doped sub-portion 10321 through the fourth via 10e. The sixth via 10f overlaps with the fourth doped portion 1063, and penetrates through the third insulating layer 1044 and the second insulating layer 1043. The fourth via 10e overlaps with the first doped sub-portion 10321 and penetrates through the first insulating layer 1042.

It should be noted that the first transistor T1 and the second transistor T2 may be connected in series.

Referring to FIGs. 4 and 5, the present disclosure further provides a display panel 30 including the array substrate 10 of any of the above-described embodiments.

Referring to FIG. 4, the display panel 30 includes an array substrate 10 and a light-emitting device layer 201. The light-emitting device layer 201 includes a light-emitting device 2011, and the light-emitting device 2011 is connected to at least one of the first transistor T1 and the second transistor T2. The light-emitting device 2011 includes, but is not limited to, at least one of an organic light-emitting diode, a quantum dot light-emitting diode, a micro light-emitting diode, and a sub-millimeter light-emitting diode.

Referring to FIG. 5, the display panel 30 includes an array substrate 10, an opposing substrate 202, and a liquid crystal layer 203, wherein the liquid crystal layer 203 is disposed between the array substrate 10 and the opposing substrate 202.

Descriptions of the above embodiments are merely intended to help understand the technical solutions and core ideas of the present disclosure. A person with ordinary skill in the art should understand that various modifications may still be made to the technical solutions described in the foregoing embodiments, or equivalents may be made to some of the technical features therein. These modifications or substitutions do not depart the essence of the corresponding technical solutions from the scope of the technical solutions of the embodiments of the present disclosure.

## Claims

1. An array substrate (10), **characterized in that** the array substrate (10) comprises:
a substrate (101); and
a first transistor (T1) disposed on the substrate (101);
wherein the first transistor (T1) comprises:
a first active layer (103) disposed on the substrate (101), and the first active layer (103) comprises a first channel portion (1031), a first doped portion (1032), and a second doped portion (1033); the first doped portion (1032) and the second doped portion (1033) are connected to opposite ends of the first channel portion (1031), respectively; the first doped portion (1032) comprises a first doped sub-portion (10321) and a second doped sub-portion (10322), and the second doped sub-portion (10322) is connected between the first channel portion (1031) and the first doped sub-portion (10321); a doping concentration of ions in the second doped sub-portion (10322) is less than a doping concentration of ions in the first doped sub-portion (10321), and the doping concentration of ions in the first doped sub-portion (10321) is the same as a doping concentration of ions in the second doped portion (1033);
a first gate (105) disposed on one side of the first active layer (103), and the first gate (105) overlaps with the first channel portion (1031); and
a source (1081) and a drain (1082), the source (1081) is connected to the second doped portion (1033) and the drain (1082) is connected to the first doped sub-portion (10321) of the first doped portion (1032).

2. The array substrate (10) according to claim 1, **characterized in that** the first gate (105) is disposed on one side of the first active layer (103) away from the substrate (101);
the array substrate (10) further comprises a second transistor (T2), and the second transistor (T2) comprises:
a second active layer (106), at least part of the second active layer (106) is disposed on one side of the first gate (105) away from the substrate (101); the second active layer (106) comprises a second channel portion (1061), a third doped portion (1062), and a fourth doped portion (1063); the third doped portion (1062) and the fourth doped portion (1063) are connected to opposite ends of the second channel portion (1061), respectively; the second channel portion (1061) overlaps with the first channel portion (1031) and the second doped portion (1033), the third doped portion (1062) overlaps with the second doped portion (1033), and the fourth doped portion (1063) overlaps with the first doped portion (1032); and
a second gate (107), the second gate (107) is disposed on one side of the second active layer (106) away from the substrate (101) and overlaps with the second channel portion (1061).

3. The array substrate (10) according to claim 2, **characterized in that** the first transistor (T1) is connected in parallel with the second transistor (T2).

4. The array substrate (10) according to claim 2, **characterized in that** the array substrate (10) further comprises a first insulating layer (1042) disposed between the first gate (105) and the second active layer (106), wherein the third doped portion (1062) is connected to the second doped portion (1033) through a first via (10a) penetrating through the first insulating layer (1042).

5. The array substrate (10) according to any one of claims 2 to 4, **characterized in that** the array substrate (10) further comprises a second insulating layer (1043) disposed between the second active layer (106) and the second gate (107), and a third insulating layer (1044) covering the second gate (107), wherein the source (1081) is disposed on the third insulating layer (1044), and the source (1081) is connected to the third doped portion (1062) through a second via (10d) penetrating through the second insulating layer (1043) and the third insulating layer (1044).

6. The array substrate (10) according to claim 5, **characterized in that** the drain (1082) is disposed on the third insulating layer (1044), and the drain (1082) is connected to the first doped sub-portion (10321) through a third via (10b) penetrating through the first insulating layer (1042), the second insulating layer (1043) and the third insulating layer (1044).

7. The array substrate (10) according to claim 6, **characterized in that** the fourth doped portion (1063) is connected to the first doped sub-portion (10321) through a fourth via (10e) penetrating through the first insulating layer (1042).

8. The array substrate (10) according to claim 6, **characterized in that** the array substrate (10) further comprises a fifth via (10c) penetrating through the second insulating layer (1043) and the third insulating layer (1044), wherein the drain (1082) is connected to the fourth doped portion (1063) through the fifth via (10c).

9. The array substrate (10) according to claim 2, **characterized in that** a thickness of the second active layer (106) is less than that of the first active layer (103).

10. A display panel (30), **characterized in that** the display panel (30) comprises the array substrate (10) according to any one of claims 1-9.

## Amended claims

### Amended claims in accordance with Rule 137(2) EPC.

1. An array substrate (10), **characterized in that** the array substrate (10) comprises:
a substrate (101); and
a first transistor (T1) disposed on the substrate (101);
wherein the first transistor (T1) comprises:
a first active layer (103) disposed on the substrate (101), and the first active layer (103) comprises a first channel portion (1031), a first doped portion (1032), and a second doped portion (1033); the first doped portion (1032) and the second doped portion (1033) are connected to opposite ends of the first channel portion (1031), respectively; the first doped portion (1032) comprises a first doped sub-portion (10321) and a second doped sub-portion (10322), and the second doped sub-portion (10322) is connected between the first channel portion (1031) and the first doped sub-portion (10321); a doping concentration of ions in the second doped sub-portion (10322) is less than a doping concentration of ions in the first doped sub-portion (10321), the doping concentration of ions in the first doped sub-portion (10321) is the same as a doping concentration of ions in the second doped portion (1033), a length of the first doped portion (1032) is greater than that of the second doped portion (1033), and the second doped portion (1033) is in direct contact with the first channel portion (1031);
a first gate (105) disposed on one side of the first active layer (103), and the first gate (105) overlaps with the first channel portion (1031); and
a source (1081) and a drain (1082), the source (1081) is connected to the second doped portion (1033) and the drain (1082) is connected to the first doped sub-portion (10321) of the first doped portion (1032).

2. The array substrate (10) according to claim 1, **characterized in that** the first gate (105) is disposed on one side of the first active layer (103) away from the substrate (101);
the array substrate (10) further comprises a second transistor (T2), and the second transistor (T2) comprises:
a second active layer (106), at least part of the second active layer (106) is disposed on one side of the first gate (105) away from the substrate (101); the second active layer (106) comprises a second channel portion (1061), a third doped portion (1062), and a fourth doped portion (1063); the third doped portion (1062) and the fourth doped portion (1063) are connected to opposite ends of the second channel portion (1061), respectively; the second channel portion (1061) overlaps with the first channel portion (1031) and the second doped portion (1033), the third doped portion (1062) overlaps with the second doped portion (1033), and the fourth doped portion (1063) overlaps with the first doped portion (1032); and
a second gate (107), the second gate (107) is disposed on one side of the second active layer (106) away from the substrate (101) and overlaps with the second channel portion (1061).

3. The array substrate (10) according to claim 2, **characterized in that** the first transistor (T1) is connected in parallel with the second transistor (T2).

4. The array substrate (10) according to claim 2, **characterized in that** the array substrate (10) further comprises a first insulating layer (1042) disposed between the first gate (105) and the second active layer (106), wherein the third doped portion (1062) is connected to the second doped portion (1033) through a first via (10a) penetrating through the first insulating layer (1042).

5. The array substrate (10) according to any one of claims 2 to 4, **characterized in that** the array substrate (10) further comprises a second insulating layer (1043) disposed between the second active layer (106) and the second gate (107), and a third insulating layer (1044) covering the second gate (107), wherein the source (1081) is disposed on the third insulating layer (1044), and the source (1081) is connected to the third doped portion (1062) through a second via (10d) penetrating through the second insulating layer (1043) and the third insulating layer (1044).

6. The array substrate (10) according to claim 5, **characterized in that** the drain (1082) is disposed on the third insulating layer (1044), and the drain (1082) is connected to the first doped sub-portion (10321) through a third via (10b) penetrating through the first insulating layer (1042), the second insulating layer (1043) and the third insulating layer (1044).

7. The array substrate (10) according to claim 6, **characterized in that** the fourth doped portion (1063) is connected to the first doped sub-portion (10321) through a fourth via (10e) penetrating through the first insulating layer (1042).

8. The array substrate (10) according to claim 6, **characterized in that** the array substrate (10) further comprises a fifth via (10c) penetrating through the second insulating layer (1043) and the third insulating layer (1044), wherein the drain (1082) is connected to the fourth doped portion (1063) through the fifth via (10c).

9. The array substrate (10) according to claim 2, **characterized in that** a thickness of the second active layer (106) is less than that of the first active layer (103).

10. A display panel (30), **characterized in that** the display panel (30) comprises the array substrate (10) according to any one of claims 1-9.
